(19)

Europäisches Patentamt

European Patent Office

Office européen des brevets

(11) **EP 3 809 467 B1**

(12) **FASCICULE DE BREVET EUROPEEN**

(45) Date de publication et mention de la délivrance du brevet:
**19.01.2022 Bulletin 2022/03**

(21) Numéro de dépôt: **20201419.7**

(22) Date de dépôt: **12.10.2020**

(51) Classification Internationale des Brevets (IPC):
***H01L 27/146*** *(2006.01)*

(52) Classification Coopérative des Brevets (CPC):
**H01L 27/14618; H01L 27/14601; H01L 27/14683;** H01L 27/14636

(54) **PROCÉDÉ DE MISE EN COURBURE COLLECTIVE D'UN ENSEMBLE DE PUCES ELÉCTRONIQUES**

VERFAHREN ZUR KOLLEKTIVEN BIEGUNG EINER GESAMTHEIT VON ELEKTRONISCHEN CHIPS

METHOD FOR COLLECTIVE CURVATURE OF A SET OF ELECTRONIC CHIPS

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **17.10.2019 FR 1911605**

(43) Date de publication de la demande:
**21.04.2021 Bulletin 2021/16**

(73) Titulaire: **Commissariat à l'Energie Atomique et aux Energies Alternatives
75015 Paris (FR)**

(72) Inventeurs:
• **CHAMBION, Bertrand
38054 GRENOBLE Cedex 09 (FR)**
• **COLONNA, Jean-Philippe
38054 GRENOBLE Cedex 09 (FR)**

(74) Mandataire: **INNOV-GROUP
310, avenue Berthelot
69372 Lyon Cedex 08 (FR)**

(56) Documents cités:
EP-A1- 3 480 850      FR-A1- 3 061 990
US-A1- 2009 115 875

## Description

### Domaine technique

L'invention se rapporte au domaine technique de la mise en courbure collective de puces électroniques. Par « collective », on entend une mise en courbure simultanée d'un ensemble de puces électroniques individualisées, c'est-à-dire après leur fabrication sur une tranche (« *wafer*» en langue anglaise) et après leur découpe au sein de la tranche. Le terme « collective » ne désigne donc pas ici une mise en courbure à l'échelle de la tranche (WLP pour « *Wafer Level Process*» en langue anglaise) sur laquelle sont formées les puces électroniques.

L'invention trouve notamment son application dans la fabrication de capteurs d'images incurvés, ou d'afficheurs incurvés, pouvant être intégrés à un système optique (e.g. un objectif photographique) afin d'augmenter la compacité du système optique, ou d'en améliorer les performances optiques (e.g. compenser la courbure de champ, l'astigmatisme).

### État de l'art

Un procédé de mise en courbure de puces électroniques connu de l'état de la technique, notamment du document US 2006/0038183 A1 (ci-après D1), comporte une étape consistant à agencer des unités de fléchissement (« *flexor unit*») pour incurver les puces électroniques. En particulier, D1 divulgue (fig. 11, §0042) une mise en courbure à l'échelle d'une puce électronique individualisée. Une unité de fléchissement comporte :

- des espaceurs («*standoff*») formés sur le substrat, et s'étendant autour de la puce électronique,
- une plaque transparente, reliant les espaceurs, et surplombant la puce électronique.

Le coefficient de dilatation thermique de la plaque transparente est adapté à celui du substrat de manière à incurver la puce électronique après un refroidissement de la plaque transparente.

Un tel procédé de l'état de la technique n'est pas entièrement satisfaisant dans la mesure où il ne permet pas :

- une réalisation aisée des contacts électriques en face arrière du substrat, afin d'assurer une liaison électrique avec un boîtier ou une carte électronique, après l'incurvation de la puce électronique,
- une mise en courbure collective au sens d'une mise en courbure simultanée d'un ensemble de puces électroniques individualisées. US 2009/115875 décrit un procédé de mise en courbure collective d'un ensemble de puces électroniques selon l'art antérieur.

### Exposé de l'invention

L'invention vise à remédier en tout ou partie aux inconvénients précités. A cet effet, l'invention a pour objet un procédé de mise en courbure collective d'un ensemble de puces électroniques, comportant les étapes :

a) prévoir l'ensemble de puces électroniques, préalablement découpées, et comportant chacune un empilement comprenant :

- une matrice de pixels,
- une couche d'interconnexions, reliée électriquement à la matrice de pixels,
- une première couche, comprenant des trous d'interconnexions reliés électriquement à la couche d'interconnexions ; l'empilement possédant une première épaisseur et un premier coefficient de dilatation thermique ;

b) assembler l'ensemble de puces électroniques découpées à un substrat support, du côté opposé aux premières couches, de manière à laisser une zone d'espacement entre les puces électroniques adjacentes ;

c) former une couche de redistribution comportant des pistes métalliques reliées électriquement aux trous d'interconnexions, les pistes métalliques présentant des extrémités latérales s'étendant dans chaque zone d'espacement ;

d) former des piliers métalliques sur les extrémités latérales des pistes métalliques ;

e) mouler un matériau sur la couche de redistribution, le matériau comportant :

- des premières portions, faisant face aux premières couches des puces électroniques,
- des deuxièmes portions, séparées des premières portions, et s'étendant dans les zones d'espacement autour des piliers métalliques ; les premières et deuxièmes portions du matériau étant coplanaires ; le matériau possédant une température de formation ;

f) appliquer un traitement thermique à la température de formation du matériau, les premières et deuxièmes portions du matériau étant solidaires mécaniquement respectivement des premières couches et du substrat support, le matériau formé possédant une seconde épaisseur, un second coefficient de dilatation thermique strictement supérieur au premier coefficient de dilatation thermique ; le ratio entre les premier et second coefficients de dilatation thermique, le ratio entre les première et seconde épaisseurs et la température de formation étant adaptés de sorte qu'à l'issue de l'étape f) l'empilement de chaque puce électronique est incurvé selon une forme convexe prédéterminée, orientée vers la matrice de pixels, à une température de fonctionnement donnée de la puce électronique correspondante ; les deuxièmes portions du matériau formé autour des piliers métalliques demeurant coplanaires à l'issue de l'étape f).

Ainsi, un tel procédé selon l'invention permet à la fois :

(i) une mise en courbure collective au sens d'une mise en courbure simultanée d'un ensemble de puces électroniques individualisées, qui sont assemblées sur un substrat support lors de l'étape b) et incurvées à l'issue de l'étape f) ;

(ii) une réalisation aisée des contacts électriques grâce aux deuxièmes portions du matériau formé autour des piliers métalliques qui sont coplanaires à l'issue de l'étape f).

En ce qui concerne le point (i), la mise en courbure provient des contraintes thermomécaniques libérées après le refroidissement du matériau à l'issue de l'étape f), c'est-à-dire lorsque le matériau est mis à la température de fonctionnement de la puce électronique. L'empilement subit des contraintes thermomécaniques en raison des premières portions du matériau formé de manière solidaire avec les premières couches (effet bilame). Par « libérer les contraintes thermomécaniques », on entend le fait de convertir les contraintes thermomécaniques subies par l'empilement en déformation (courbure).

En ce qui concerne le point (ii), les deuxièmes portions du matériau demeurent coplanaires (i.e. ne s'incurvent pas) à l'issue de l'étape f), contrairement aux premières portions du matériau, car d'une part, les deuxièmes portions du matériau sont séparées des premières portions lors de l'étape e), et d'autre part, les deuxièmes portions du matériau sont solidaires mécaniquement du substrat support lors de l'étape f).

Définitions

- Par «puce électronique» («*die*» ou «*chip*» en langue anglaise), on entend une partie d'un substrat ayant subie des étapes technologiques en vue de former un composant électronique destiné à être monté sur une carte électronique ou dans un boîtier.
- Par « substrat », on entend un support physique autoporté.
- Par « pixels », on entend :

les cellules photosensibles (appelées également photosites) dans le cas d'une puce électronique d'un capteur d'images,
les cellules émettrices de lumière (ou émissives) dans le cas d'une puce électronique d'un afficheur.

- Par « couche d'interconnexions », on entend un empilement de niveaux d'interconnexions comprenant des pistes métalliques noyées dans un matériau diélectrique.
- Par «trou d'interconnexion » («via» en langue anglaise), on entend un trou métallisé permettant d'établir une liaison électrique avec la couche d'interconnexions. Dans le cas où la première couche est réalisée en silicium, le trou d'interconnexion est de type TSV (« *Through Silicon Via* » en langue anglaise).
- Par « couche de redistribution », on entend une couche permettant de redistribuer (rerouter) des pistes d'interconnexions en périphérie de la puce électronique afin de déporter les futurs contacts électriques.
- Par «solidaires mécaniquement», on entend que les premières portions du matériau présentent une énergie d'adhérence suffisante avec les premières couches pour obtenir la mise en courbure des empilements et éviter leur décollement des empilements. De la même façon, on entend que les deuxièmes portions du matériau présentent une énergie d'adhérence suffisante avec le substrat support (et le cas échéant avec toute couche intercalée entre le substrat support et les deuxièmes portions du matériau) pour éviter leur décollement.
- Par « prédéterminée », on entend la forme convexe souhaitée pour l'application envisagée.
- Par « orientée vers la matrice de pixels », on entend que la forme convexe obtenue à l'issue de l'étape f) définit des surfaces convexes (bombées) au sein de l'empilement qui pointent vers la surface libre de l'empilement, du côté de la matrice de pixels, à l'opposé des trous d'interconnexions.

Le procédé selon l'invention peut comporter une ou plusieurs des caractéristiques suivantes.

Selon une caractéristique de l'invention, l'étape f) est précédée d'une étape $e_1$) consistant à aplanir le matériau de manière à libérer les piliers métalliques.

- Par « aplanir », on entend que les extrémités libres des piliers métalliques (entourées des deuxièmes portions du matériau) s'étendent dans un même plan avec une tolérance de 100 $\mu$m, préférentiellement de 50 $\mu$m, plus préférentiellement de 25 $\mu$m. La tolérance correspond à la distance maximale entre le plan et une extrémité libre d'un pilier métallique. On choisira avantageusement une tolérance inférieure au quart de la dimension caractéristique (e.g. diamètre) des billes de soudure envisagées pour assurer une liaison électrique entre les piliers métalliques et un boîtier (ou une carte électronique). Par exemple, pour des billes de soudure possédant un diamètre de 100 $\mu$m, la tolérance est inférieure à 25 $\mu$m.

Selon une caractéristique de l'invention, le procédé comporte une étape g) consistant à former des billes de soudure sur les deuxièmes portions du matériau à l'issue de l'étape f), les billes de soudure étant en contact avec les piliers métalliques.

Le terme « bille de soudure » couvre également le terme de « bille de brasure » où le matériau d'apport est différent des matériaux à assembler.

Ainsi, un avantage procuré est de pouvoir établir une liaison électrique avec une carte électronique (ou avec un boîtier).

Selon une caractéristique de l'invention, l'étape g) est suivie d'une étape h) consistant à découper les puces électroniques.

L'étape h) permet d'individualiser les puces avant leur mise en boîtier -ou encapsulation-(«*packaging*» en langue anglaise).

Selon une caractéristique de l'invention, l'étape b) est exécutée de sorte que le substrat support est transparent dans le domaine spectral de fonctionnement des puces électroniques.

Ainsi, un avantage procuré est de pouvoir utiliser le substrat support comme capot de protection des puces électroniques. Cela permet de s'affranchir d'étapes ultérieures de mise en boîtier ou d'encapsulation («*packaging*» en langue anglaise) des puces électroniques après l'étape h) de découpe.

Selon une caractéristique de l'invention, l'étape b) est exécutée de sorte que le substrat support comporte des espaceurs sur lesquels sont assemblées les puces électroniques découpées.

Ainsi, les espaceurs permettent de délimiter une zone d'espacement entre les puces électroniques adjacentes. Les espaceurs sont solidaires mécaniquement du substrat support.

Selon une caractéristique de l'invention, l'étape c) comporte les étapes :

> $c_1$) former une couche diélectrique remplissant les zones d'espacement de manière à affleurer les premières couches des puces électroniques, la couche diélectrique étant solidaire mécaniquement du substrat support ;
>
> $c_2$) former la couche de redistribution s'étendant sur les premières couches des puces électroniques et sur la couche diélectrique, la couche de redistribution étant solidaire mécaniquement des premières couches et de la couche diélectrique.

Ainsi, il est rendu possible de déporter les futurs contacts électriques en périphérie des puces électriques grâce à la couche diélectrique et à la couche de redistribution. L'étape f) est exécutée de sorte que les premières et deuxièmes portions du matériau sont solidaires mécaniquement de la couche de redistribution. Il en résulte que les premières et deuxièmes portions du matériau sont solidaires mécaniquement, de manière indirecte, respectivement des premières couches et du substrat support.

Selon une caractéristique de l'invention, l'étape a) comporte les étapes :

> $a_1$) prévoir un premier substrat, sur lequel est formé l'ensemble de puces électroniques ;
>
> $a_2$) assembler un substrat temporaire à l'ensemble de puces électroniques ;
>
> $a_3$) amincir le premier substrat jusqu'à l'obtention de la première couche ;
>
> $a_4$) former les trous d'interconnexions dans la première couche ;
>
> $a_5$) découper individuellement les puces électroniques.

Ainsi, un avantage procuré par l'amincissement du premier substrat est de favoriser la mise en courbure des puces électroniques à l'issue de l'étape f).

Selon une caractéristique de l'invention, l'étape a) est exécutée de sorte que :

- la couche d'interconnexions est formée sur la première couche,
- la matrice de pixels est formée sur la couche d'interconnexions,
- l'empilement comprend une matrice de lentilles de focalisation, formé sur la matrice de pixels.

Ainsi, on obtient un capteur d'images de type BSI («*Back Side Illuminated*» en langue anglaise). La lumière incidente pénètre dans la matrice de pixels qui est située en amont de la couche d'interconnexions, ce qui évite les déperditions énergétiques, et par là-même augmente la sensibilité du capteur d'images.

Selon une caractéristique de l'invention, l'étape a) est exécutée de sorte que :

- la matrice de pixels est formée sur la première couche,
- la couche d'interconnexions est formée sur la matrice de pixels,
- l'empilement comprend une matrice de lentilles de focalisation, formée sur la couche d'interconnexions.

Ainsi, on obtient un capteur d'images de type FSI («*Front Side Illuminated*» en langue anglaise). La lumière incidente pénètre par la couche d'interconnexions et la matrice de pixels est située en aval de la couche d'interconnexions.

Selon une caractéristique de l'invention, l'étape e) est exécutée de sorte que le matériau est un polymère thermodurcissable, de préférence choisi parmi une résine époxy et une résine polysiloxane.

Ainsi, un avantage procuré est de pouvoir mouler le matériau à l'aide d'un moule d'injection.

Selon une caractéristique de l'invention, l'étape f) est exécutée de sorte que les premier et second coefficients de dilatation thermique vérifient :

$$\frac{\alpha_2}{\alpha_1} \geq 4$$

, préférentiellement $\frac{\alpha_2}{\alpha_1} \geq 6$ , où :

- $\alpha_1$ est le coefficient de dilatation thermique de l'empilement,
- $\alpha_2$ est le coefficient de dilatation thermique du matériau formé.

Ainsi, un avantage procuré est d'autoriser des rayons de courbure élevés pour la forme convexe, et par là-même pour les puces électroniques. Le rayon de courbure peut être calculé en fonction de $\alpha_1$ et de $\alpha_2$ par la formule de Stoney.

Selon caractéristique de l'invention, l'étape f) est exécutée de sorte que le matériau formé possède un module de Young supérieur à 100 MPa, de préférence supérieur à 1 GPa, plus préférentiellement supérieur à 3 GPa.

Ainsi, un avantage procuré est d'obtenir une rigidité satisfaisante du matériau autorisant la courbure souhaitée de l'empilement lors de l'étape f).

**Brève description des dessins**

D'autres caractéristiques et avantages apparaîtront dans l'exposé détaillé de différents modes de réalisation de l'invention, l'exposé étant assorti d'exemples et de références aux dessins joints.

Figures 1a à 1d sont des vues schématiques en coupe illustrant la préparation de capteurs d'images de type FSI lors de l'étape a) d'un procédé selon l'invention.

Figures 2a à 2d sont des vues schématiques en coupe illustrant la préparation de capteurs d'images de type BSI lors de l'étape a) d'un procédé selon l'invention.

Figures 3a à 3j sont des vues schématiques en coupe illustrant un mode de mise en œuvre d'un procédé selon l'invention pour un capteur d'images de type FSI.

Figures 4a à 4j sont des vues schématiques en coupe illustrant un mode de mise en œuvre d'un procédé selon l'invention pour un capteur d'images de type BSI.

Figure 5 est une vue schématique partielle en coupe d'un capteur d'images de type FSI prévu lors de l'étape a) d'un procédé selon l'invention.

Figure 6 est une vue schématique partielle en coupe d'un capteur d'images de type BSI prévu lors de l'étape a) d'un procédé selon l'invention. Les traits pointillés désignent l'interface de collage.

Figure 7 est une vue schématique partielle en coupe d'un capteur d'images empilé de type BSI (« *3D stacked BSI*» en langue anglaise) prévu lors de l'étape a) d'un procédé selon l'invention. Les traits pointillés désignent l'interface de collage.

Il est à noter que les dessins décrits ci-avant sont schématiques et ne sont pas à l'échelle par souci de lisibilité et pour simplifier leur compréhension.

**Exposé détaillé des modes de réalisation**

Les éléments identiques ou assurant la même fonction porteront les mêmes références pour les différents modes de réalisation, par souci de simplification.

Un objet de l'invention est un procédé de mise en courbure collective d'un ensemble de puces électroniques P, comportant les étapes :

a) prévoir l'ensemble de puces électroniques P, préalablement découpées, et comportant chacune un empilement comprenant :

- une matrice de pixels 2,
- une couche d'interconnexions 3, reliée électriquement à la matrice de pixels 2,
- une première couche 1, comprenant des trous d'interconnexions 100 reliés électriquement à la couche d'interconnexions 3; l'empilement possédant une première épaisseur et un premier coefficient de dilatation thermique ;

b) assembler l'ensemble de puces électroniques P découpées à un substrat support SS, du côté opposé aux premières couches 1, de manière à laisser une zone d'espacement ZE entre les puces électroniques P adjacentes ;

c) former une couche de redistribution 4 comportant des pistes métalliques 40 reliées électriquement aux trous d'interconnexions 100, les pistes métalliques 40 présentant des extrémités latérales 400 s'étendant dans chaque zone d'espacement ZE ;

d) former des piliers métalliques PM sur les extrémités latérales 400 des pistes métalliques 40 ;

e) mouler un matériau 5 sur la couche de redistribution 4, le matériau 5 comportant :

- des premières portions 50, faisant face aux premières couches 1 des puces électroniques P,
- des deuxièmes portions 51, séparées des premières portions 50, et s'étendant dans les zones d'espacement ZE autour des piliers métalliques PM ; les premières et deuxièmes portions 50, 51 du matériau 5 étant coplanaires ; le matériau 5 possédant une température de formation ;

f) appliquer un traitement thermique à la température de formation du matériau 5, les premières et deuxièmes portions 50, 51 du matériau 5 étant solidaires mécaniquement respectivement des premières couches 1 et du substrat support SS, le matériau 5 formé possédant une seconde épaisseur, un second coefficient de dilatation thermique strictement supérieur au premier coefficient de dilatation thermique ; le ratio entre les premier et second coefficients de dilatation thermique, le ratio entre les première et seconde épaisseurs et la température de formation étant adaptés de sorte qu'à l'issue de l'étape f) l'empilement de chaque puce électronique P est incurvé selon une forme convexe prédéterminée, orientée vers la matrice de pixels 2, à une température de fonctionnement donnée de la puce électronique P correspondante ; les deuxièmes portions 51 du matériau 5 formé autour des piliers métalliques PM demeurant coplanaires à l'issue de l'étape f).

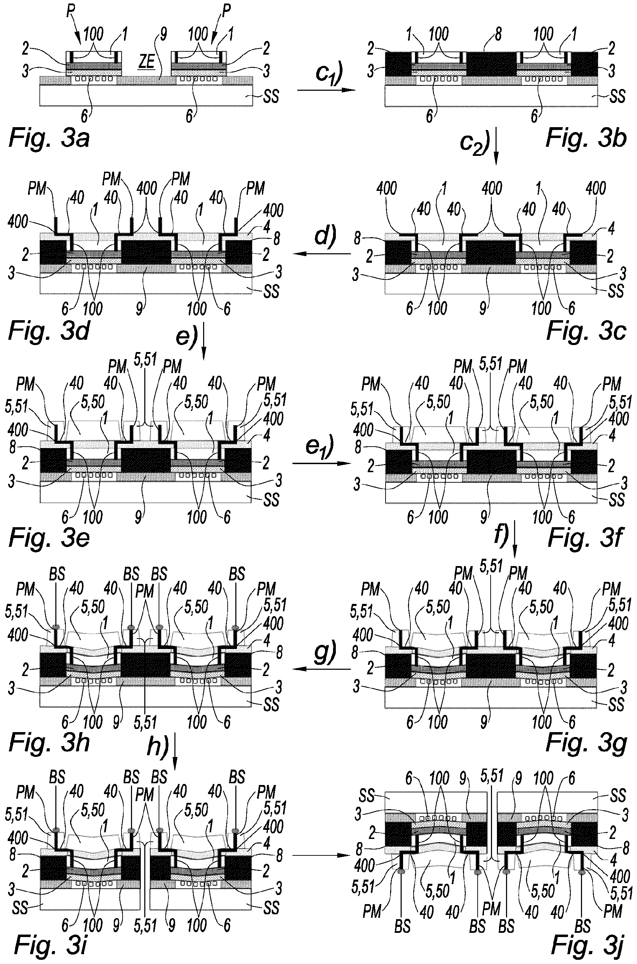

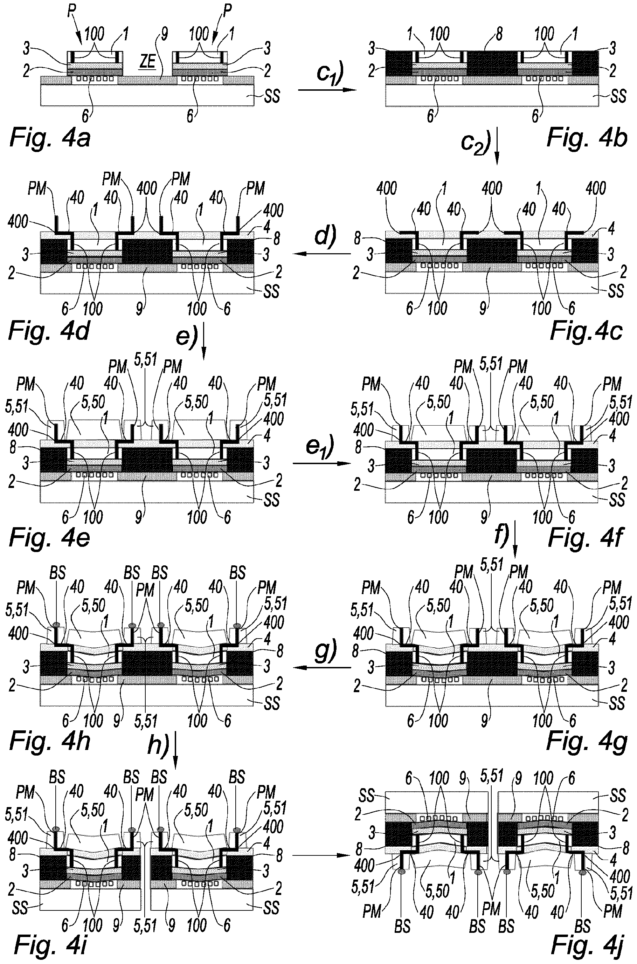

L'étape b) est illustrée aux figures 3a et 4a. L'étape c) est illustrée aux figures 3b-3c et 4b-4c. L'étape d) est illustrée aux figures 3d et 4d. L'étape e) est illustrée aux figures 3e et 4e. L'étape f) est illustrée aux figures 3g et 4g.

## Première couche

La première couche 1 comprend des première et seconde surfaces 10, 11 opposées. La première couche 1 est avantageusement obtenue à partir d'un premier substrat 1' aminci pour favoriser la mise en courbure des puces électroniques P. La première couche 1 présente avantageusement une épaisseur inférieure à 500 $\mu$m, préférentiellement inférieure à 100 $\mu$m, plus préférentiellement inférieure à 50 $\mu$m. Une telle gamme d'épaisseur permet de favoriser la mise en courbure à l'issue de l'étape f). La première couche 1 est avantageusement réalisée dans un matériau semi-conducteur, de préférence le silicium. Dans le cas où la première couche 1 est réalisée en silicium, les trous d'interconnexion 100 sont de type TSV (« *Through Silicon Via* » en langue anglaise).

## Capteur d'images FSI

L'étape a) peut être exécutée de sorte que :

- la matrice de pixels 2 est formée sur la première couche 1,
- la couche d'interconnexions 3 est formée sur la matrice de pixels 2,
- l'empilement comprend une matrice de lentilles de focalisation 6, formée sur la couche d'interconnexions 3.

Plus précisément, la matrice de pixels 2 est formée à la première surface 10 de la première couche 1. Par «formé à la surface », on entend formé sur ou à travers la surface. Ainsi, lorsque les puces électroniques P sont des capteurs d'images de type FSI (« *Front Side Illuminated* » en langue anglaise), la lumière incidente pénètre par la couche d'interconnexions 3 et la matrice de pixels 2 est située en aval de la couche d'interconnexions 3.

Il est à noter que la matrice de lentilles de focalisation 6 peut être optionnelle pour certains types de capteurs, notamment pour les capteurs infrarouges refroidis.

## Capteur d'images BSI

L'étape a) peut être exécutée de sorte que :

- la couche d'interconnexions 3 est formée sur la première couche 1,
- la matrice de pixels 2 est formée sur la couche d'interconnexions 3,
- l'empilement comprend une matrice de lentilles de focalisation 6, formé sur la matrice de pixels 2.

Plus précisément, la couche d'interconnexions 3 est formée à la première surface 10 de la première couche 1. Par « formé à la surface », on entend formé sur ou à travers la surface. Ainsi, lorsque les puces électroniques P sont des capteurs d'images de type BSI (« *Back Side Illuminated*» en langue anglaise), la lumière incidente pénètre dans la matrice de pixels 2 qui est située en amont de la couche d'interconnexions 3, ce qui évite les déperditions énergétiques, et par là-même augmente la sensibilité du capteur d'images.

Il est à noter que la matrice de lentilles de focalisation 6 peut être optionnelle pour certains types de capteurs, notamment pour les capteurs infrarouges refroidis.

## Préparation des puces électroniques

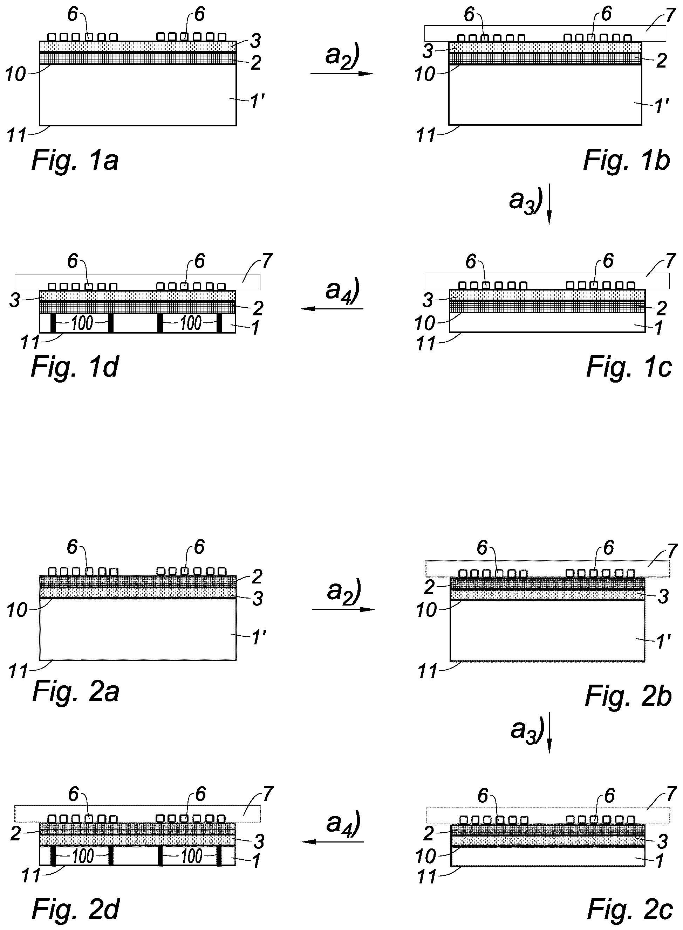

Comme illustré aux figures 1a à 1d et 2a à 2d, l'étape a) comporte avantageusement les étapes :

$a_1$) prévoir un premier substrat 1', sur lequel est formé l'ensemble de puces électroniques P;
$a_2$) assembler un substrat temporaire 7 à l'ensemble de puces électroniques P ;
$a_3$) amincir le premier substrat 1' jusqu'à l'obtention de la première couche 1 ;
$a_4$) former les trous d'interconnexions 100 dans la première couche 1 ;
$a_5$) découper individuellement les puces électroniques P.

Dans le cas d'un capteur d'images FSI illustré aux figures 1a à 1d, l'étape $a_2$) est exécutée de sorte que le substrat temporaire 7 est assemblé à la couche d'interconnexions 3. A titre d'exemple non limitatif, le substrat temporaire 7 assemblé lors de l'étape $a_2$) peut être un film adhésif, agencé du côté de la couche d'interconnexions 3, et aspiré par un plateau de maintien à vide d'une tranche (« *vacuum chuck*» en langue anglaise). L'utilisation du substrat temporaire 7 autorise l'amincissement du premier substrat 1' afin d'assurer la tenue mécanique de l'empilement.

L'étape $a_3$) est préférentiellement exécutée par un polissage mécano-chimique, précédé d'un meulage («*grinding*» en langue anglaise).

Comme illustré à la figure 1d, l'étape a₄) consiste à former des trous d'interconnexions 100, traversant la première couche 1, et reliés électriquement à la couche d'interconnexions 3.

A titre d'exemples non limitatifs, l'étape a₅) peut être exécutée à l'aide d'une scie circulaire de précision, avec une lame à âme métallique diamantée ou à âme résinoïde.

Dans le cas d'un capteur d'images BSI illustré aux figures 2a à 2d, l'étape a₂) est exécutée de sorte que le substrat temporaire 7 est assemblé aux matrices de pixels 2. A titre d'exemple non limitatif, le substrat temporaire 7 assemblé lors de l'étape a₂) peut être un film adhésif, agencé du côté des matrices de pixels 2, et aspiré par un plateau de maintien à vide d'une tranche («*vacuum chuck*» en langue anglaise). L'utilisation du substrat temporaire 7 autorise l'amincissement du premier substrat 1'afin d'assurer la tenue mécanique de l'empilement.

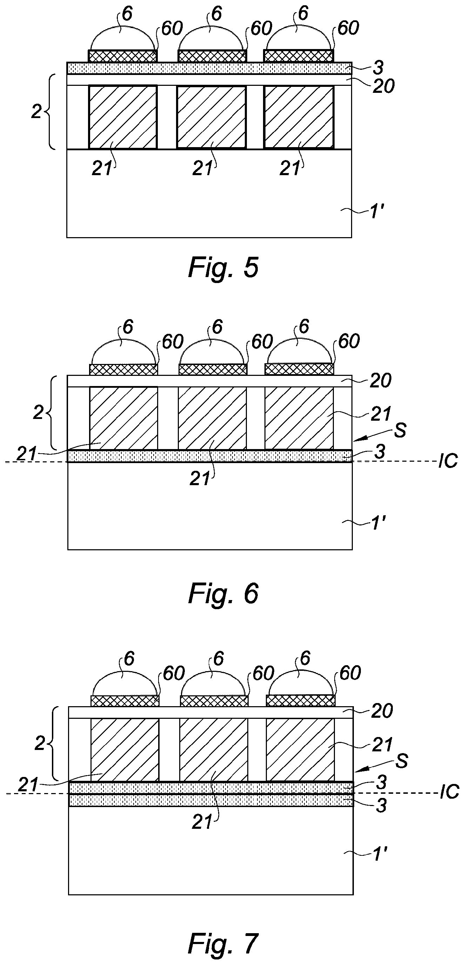

Comme illustré aux figures 6 et 7, l'ensemble de puces électroniques P peut être formé avant l'étape a₁) au sein d'un substrat S qui est ensuite collé au premier substrat 1'. Les traits pointillés désignent l'interface de collage IC. Comme illustré à la figure 7, le premier substrat 1' peut être muni d'un circuit de lecture capable de lire simultanément chaque pixel d'une matrice formée dans le substrat S.

L'étape a₃) est préférentiellement exécutée par un polissage mécano-chimique, précédé d'un meulage («*grinding*» en langue anglaise).

Comme illustré à la figure 2d, l'étape a₄) consiste à former des trous d'interconnexions 100, traversant la première couche 1, et reliés électriquement à la couche d'interconnexions 3.

A titre d'exemples non limitatifs, l'étape a₅) peut être exécutée à l'aide d'une scie circulaire de précision, avec une lame à âme métallique diamantée ou à âme résinoïde.

Couche d'interconnexions

La couche d'interconnexions 3 est un empilement de niveaux d'interconnexions comprenant des pistes métalliques noyées dans un matériau diélectrique. A titre d'exemples non limitatifs, les pistes métalliques peuvent être réalisées en cuivre, tungstène, titane ou en aluminium, et le matériau diélectrique peut être organique (un polymère tel qu'un polyimide, ou ALX commercialisé par la société ASAHI GLASS) ou inorganique (SiO₂, SiN...).

Matrice de pixels

Les pixels 2 peuvent être des cellules photosensibles (appelées également photosites) dans le cas d'une puce électronique P d'un capteur d'images. Les pixels 2 peuvent être des cellules émettrices de lumière (ou émissives) dans le cas d'une puce électronique P d'un afficheur.

Comme illustré aux figures 5 à 7, lorsque la puce électronique P est un capteur d'images, la matrice de pixels 2 est avantageusement munie de photodiodes 21 reliées à la surface de réception 20 de la lumière incidente. La matrice de pixels 2 est avantageusement munie d'un circuit de type CMOS (« *Complementary Metal Oxide Semiconductor*» en langue anglaise) configuré pour traiter le signal électrique généré par les photodiodes 21 (amplification du signal, sélection du pixel...).

Lorsque la puce électronique P est un afficheur, la matrice de pixels 2 est avantageusement munie de diodes électroluminescentes (non illustrées). Les diodes électroluminescentes peuvent être organiques ou inorganiques. La matrice de pixels 2 est avantageusement munie d'un circuit de type CMOS configuré pour commander les diodes électroluminescentes.

Comme illustré aux figures 5 à 7, la matrice de pixels 2 est avantageusement munie de filtres colorés 60. Lorsque la puce électronique P est un capteur d'images, les filtres colorés 60 sont avantageusement agencés en matrice de Bayer. Les filtres colorés 60 sont interposés entre la surface de réception 20 de la lumière incidente et la matrice de lentilles de focalisation 6.

Matrice de lentilles de focalisation

Dans le cas d'une puce électronique P d'un capteur d'images comportant une matrice de lentilles de focalisation 6, les lentilles de focalisation 6 sont convergentes de manière à concentrer la lumière incidente vers la matrice de pixels 2. Chaque lentille de focalisation 6 est associée à un pixel. Les lentilles de focalisation 6 sont préférentiellement des microlentilles.

**Substrat** support

L'étape b) est avantageusement exécutée de sorte que le substrat support SS est transparent dans le domaine spectral de fonctionnement des puces électroniques P. A titre d'exemple non limitatif, le substrat support SS peut être réalisé en verre.

Les puces électroniques P, préalablement découpées, sont avantageusement transférées sur le substrat support SS lors de l'étape b) à l'aide d'une machine de placement de composants électroniques (« *Pick-and-Place*» en langue anglaise).

L'étape b) est avantageusement exécutée de sorte que le substrat support SS comporte des espaceurs 9 sur lesquels sont assemblées les puces électroniques P découpées. Les puces électroniques P sont préférentiellement collées aux espaceurs 9 à l'aide d'une colle thixotrope.

Couche de redistribution

L'étape c) comporte avantageusement les

étapes :

> $c_1$) former une couche diélectrique 8 remplissant les zones d'espacement ZE de manière à affleurer les premières couches 1 des puces électroniques P, la couche diélectrique 8 étant solidaire mécaniquement du substrat support SS ;
> $c_2$) former la couche de redistribution 4 s'étendant sur les premières couches 1 des puces électroniques P et sur la couche diélectrique 8, la couche de redistribution 4 étant solidaire mécaniquement des premières couches 1 et de la couche diélectrique 8.

L'étape $c_1$) est illustrée aux figures 3b et 4b. L'étape $c_2$) est illustrée aux figures 3c et 4c.

La couche diélectrique 8 formée lors de l'étape $c_1$) peut être une résine, par exemple une résine SINR™, commercialisée par la société Shin-Etsu MicroSi, ou un polyimide. L'étape $c_1$) est exécutée de sorte que la couche diélectrique 8 est formée sur les espaceurs 9.

Plus précisément, l'étape $c_2$) est exécutée de sorte que la couche de redistribution 4 s'étend à la seconde surface 11 des premières couches 1 des puces électroniques P et sur la couche diélectrique 8.

La couche de redistribution 4 comporte des pistes métalliques 40 noyées dans un matériau diélectrique. A titre d'exemples non limitatifs, les pistes métalliques 40 peuvent être réalisées en Cu, Al, W, Ti. Le matériau diélectrique peut être une résine, par exemple une résine SINR™, ou un polyimide.

Piliers métalliques

Les piliers métalliques PM sont de préférence réalisés en aluminium ou en cuivre.

Par exemple, une couche de germination métallique (« *seed layer*» en langue anglaise) peut être déposée sur la couche de redistribution 4.

La couche de germination permet le contact électrique pleine plaque pour la future croissance électrochimique des piliers métalliques PM. La couche de germination peut comporter plusieurs sous-couches, dont une sous-couche adaptée pour l'accroche mécanique. La couche de germination peut présenter une épaisseur de l'ordre de 300 nm. A titre d'exemple non limitatif, la couche de germination peut comporter une première sous-couche en Ti de 100 nm et une deuxième sous-couche en Cu de 200 nm. Ensuite, une résine de photolithographie peut être déposée sur la couche de germination, puis exposée à un rayonnement ultraviolet à travers un masque de manière à former des motifs délimitant les futurs piliers métalliques PM. L'épaisseur de la résine de photolithographie est choisie de manière à être égale à la hauteur des futurs piliers métalliques PM. La couche de germination est ensuite polarisée dans un bain dédié permettant la croissance électrochimique des piliers métalliques PM. Enfin, la résine de photolithographie est retirée, et la partie de la couche de germination s'étendant sous la résine de photolithographie lors de la croissance électrochimique est gravée.

L'étape f) est avantageusement précédée d'une étape $e_1$) consistant à aplanir le matériau 5 de manière à libérer les piliers métalliques PM. L'étape $e_1$) est illustrée aux figures 3f et 4f. A titre d'exemples non limitatifs, l'étape $e_1$) peut être exécutée par un polissage mécano-chimique ou par gravure plasma.

**Matériau**

Le matériau 5 formé lors de l'étape f) est solidaire mécaniquement de la couche de redistribution 4. La couche de redistribution 4 étant solidaire mécaniquement des premières couches 1 des puces électroniques P, les premières portions 50 du matériau 5 formé lors de l'étape f) sont solidaires mécaniquement (indirectement) des premières couches 1 des puces électroniques P. En outre, les deuxièmes portions 51 du matériau 5 formées lors de l'étape f) sont solidaires mécaniquement (indirectement) du substrat support SS. En effet, les espaceurs 9 sont solidaires mécaniquement du substrat support SS, la couche diélectrique 8 est solidaire mécaniquement des espaceurs 9, et la couche de redistribution 4 est solidaire mécaniquement de la couche diélectrique 8.

L'étape f) est avantageusement exécutée de sorte que les premier et second coefficients de dilatation thermique vérifient :

$$\frac{\alpha_2}{\alpha_1} \geq 4 \text{, préférentiellement } \frac{\alpha_2}{\alpha_1} \geq 6 \text{, où :}$$

- $\alpha_1$ est le coefficient de dilatation thermique de l'empilement,
- $\alpha_2$ est le coefficient de dilatation thermique du matériau 5 formé.

Il est possible de mesurer le coefficient de dilatation thermique de l'empilement par une technique connue de l'homme du métier, comme décrit dans le chapitre 2 du document «ASM Ready Reference : Thermal Properties of Metals», ASM International, 2002, ou encore dans le document B. Cassel et al., «Coefficient ofThermal Expansion Measurement using the TMA 4000», PerkinElmer, Inc., 2013.

En première approximation, le coefficient de dilatation thermique de l'empilement est sensiblement égal au coefficient de dilatation thermique de la première couche 1 dans la mesure où l'épaisseur de la première couche 1 est prédominante dans l'empilement. Lorsque la première couche 1 est réalisée en silicium, $\alpha_1$ est de l'ordre de $2,5 \cdot 10^{-6}$ K$^{-1}$. On choisira donc le matériau 5 avec $\alpha_2$ tel que $\alpha_2 \geq 10^{-5}$ K$^{-1}$, préférentiellement $\alpha_2 \geq 1,5 \cdot 10^{-5}$ K$^{-1}$. Le rayon de courbure obtenu à l'issue de l'étape f) peut être calculé en fonction de $\alpha_1$ et $\alpha_2$ grâce à la formule de Stoney, connue de l'homme du métier.

L'étape f) est avantageusement exécutée de sorte que le matériau 5 formé possède un module de Young supérieur à 100 MPa, de préférence supérieur à 1 GPa, plus préférentiellement supérieur à 3 GPa.

Le matériau 5 formé présente avantageusement une seconde épaisseur comprise entre 120 μm et 600 μm. Le matériau 5 peut être monocouche ou multicouche. En première approximation, le ratio entre la première épaisseur (de l'empilement) et la seconde épaisseur (du matériau 5 formé) qui influence la courbure de la forme convexe peut être considéré comme gouverné par le ratio entre l'épaisseur de la première couche 1 et la seconde épaisseur dans la mesure où l'épaisseur de la première couche 1 est prédominante dans l'empilement. On choisira de préférence une seconde épaisseur du matériau 5 formé de l'ordre de 2,5 fois supérieure à l'épaisseur de la première couche 1 lorsque la première couche 1 est en silicium afin d'optimiser la courbure de la forme convexe selon l'application envisagée. Lorsque le matériau 5 est poli lors de l'étape $e_1$), la seconde épaisseur du matériau 5 poli est avantageusement au moins 2 fois supérieure à l'épaisseur de la première couche 1 lorsque la première couche 1 est en silicium. Ainsi, la courbure de la forme convexe est peu affectée à l'issue de l'étape f).

L'étape e) est avantageusement exécutée de sorte que le matériau 5 est un polymère thermodurcissable, de préférence choisi parmi une résine époxy et une résine polysiloxane. Le cas échéant, le second coefficient de dilatation thermique est le coefficient de dilatation thermique du polymère durci. A titre d'exemples non limitatifs, le polymère thermodurcissable peut être :

- une résine époxy, avec un module de Young de l'ordre de 9 GPa, $\alpha_2$ compris entre 3,1 $10^{-5}$ $K^{-1}$ et 1,14 $10^{-4}$ $K^{-1}$, et une température de réticulation de l'ordre de 71°C ;
- une résine polysiloxane, avec un module de Young de l'ordre de 3,3 GPa, $\alpha_2$ compris entre 2 $10^{-5}$ $K^{-1}$ et 9,1 $10^{-5}$ $K^{-1}$, et une température de réticulation de l'ordre de 180°C.

Le matériau 5 possède une température de formation (e.g. température de réticulation) strictement supérieure à la température de fonctionnement donnée des puces électroniques P. L'étape e) est préférentiellement exécutée à l'aide d'un moule d'injection. Le moule d'injection est réalisé dans un matériau réfractaire à la température de formation du matériau 5, par exemple la température de réticulation du polymère thermodurcissable. Le moule d'injection est préférentiellement réalisé en silicone.

## Forme convexe prédéterminée

La forme convexe prédéterminée peut avoir un rayon de courbure constant ou variable (de même signe). La forme convexe prédéterminée peut être asphérique. Le rayon de courbure (constant ou variable) est prédéterminé selon l'application envisagée.

## Finalisation

Le procédé comporte avantageusement une étape g) consistant à former des billes de soudure BS sur les deuxièmes portions 51 du matériau 5 à l'issue de l'étape f), les billes de soudure BS étant en contact avec les piliers métalliques PM. L'étape g) est illustrée aux figures 3h et 4h.

L'étape g) est avantageusement suivie d'une étape h) consistant à découper les puces électroniques P. L'étape h) est illustrée aux figures 3i et 4i. A titre d'exemples non limitatifs, l'étape h) peut être exécutée à l'aide d'une scie circulaire de précision, avec une lame à âme métallique diamantée ou à âme résinoïde.

L'invention ne se limite pas aux modes de réalisation exposés. L'homme du métier est mis à même de considérer leurs combinaisons techniquement opérantes, et de leur substituer des équivalents.

## Revendications

1. Procédé de mise en courbure collective d'un ensemble de puces électroniques (P), comportant les étapes :

    a) prévoir l'ensemble de puces électroniques (P), préalablement découpées, et comportant chacune un empilement comprenant :

        - une matrice de pixels (2),
        - une couche d'interconnexions (3), reliée électriquement à la matrice de pixels (2),
        - une première couche (1), comprenant des trous d'interconnexions (100) reliés électriquement à la couche d'interconnexions (3); l'empilement possédant une première épaisseur et un premier coefficient de dilatation thermique ;

    b) assembler l'ensemble de puces électroniques (P) découpées à un substrat support (SS), du côté opposé aux premières couches (1), de manière à laisser une zone d'espacement (ZE) entre les puces électroniques (P) adjacentes ;
    c) former une couche de redistribution (4) comportant des pistes métalliques (40) reliées électriquement aux trous d'interconnexions (100), les pistes métalliques (40) présentant des extrémités latérales (400) s'étendant dans chaque zone d'espacement (ZE) ;
    d) former des piliers métalliques (PM) sur les extrémités latérales (400) des pistes métalliques (40) ;
    e) mouler un matériau (5) sur la couche de redistribution (4), le matériau (5) comportant :

        - des premières portions (50), faisant face aux premières couches (1) des puces électroniques (P),
- des deuxièmes portions (51), séparées des premières portions (50), et s'étendant dans les zones d'espacement (ZE) autour des piliers métalliques (PM) ; les premières et deuxièmes portions (50, 51) du matériau (5) étant coplanaires ; le matériau (5) possédant une température de formation ;

f) appliquer un traitement thermique à la température de formation du matériau (5), les premières et deuxièmes portions (50, 51) du matériau (5) étant solidaires mécaniquement respectivement des premières couches (1) et du substrat support (SS), le matériau (5) formé possédant une seconde épaisseur, un second coefficient de dilatation thermique strictement supérieur au premier coefficient de dilatation thermique ; le ratio entre les premier et second coefficients de dilatation thermique, le ratio entre les première et seconde épaisseurs et la température de formation étant adaptés de sorte qu'à l'issue de l'étape f) l'empilement de chaque puce électronique (P) est incurvé selon une forme convexe prédéterminée, orientée vers la matrice de pixels (2), à une température de fonctionnement donnée de la puce électronique (P) correspondante ; les deuxièmes portions (51) du matériau (5) formé autour des piliers métalliques (PM) demeurant coplanaires à l'issue de l'étape f).

2. Procédé selon la revendication 1, dans lequel l'étape f) est précédée d'une étape $e_1$) consistant à aplanir le matériau (5) de manière à libérer les piliers métalliques (PM).

3. Procédé selon la revendication 1 ou 2, comportant une étape g) consistant à former des billes de soudure (BS) sur les deuxièmes portions (51) du matériau (5) à l'issue de l'étape f), les billes de soudure (BS) étant en contact avec les piliers métalliques (PM).

4. Procédé selon la revendication 3, dans lequel l'étape g) est suivie d'une étape h) consistant à découper les puces électroniques (P).

5. Procédé selon l'une des revendications 1 à 4, dans lequel l'étape b) est exécutée de sorte que le substrat support (SS) est transparent dans le domaine spectral de fonctionnement des puces électroniques (P).

6. Procédé selon l'une des revendications 1 à 5, dans lequel l'étape b) est exécutée de sorte que le substrat support (SS) comporte des espaceurs (9) sur lesquels sont assemblées les puces électroniques (P) découpées.

7. Procédé selon l'une des revendications 1 à 6, dans lequel l'étape c) comporte les étapes :

$c_1$) former une couche diélectrique (8) remplissant les zones d'espacement (ZE) de manière à affleurer les premières couches (1) des puces électroniques (P), la couche diélectrique (8) étant solidaire mécaniquement du substrat support (SS) ;
$c_2$) former la couche de redistribution (4) s'étendant sur les premières couches (1) des puces électroniques (P) et sur la couche diélectrique (8), la couche de redistribution (4) étant solidaire mécaniquement des premières couches (1) et de la couche diélectrique (8).

8. Procédé selon l'une des revendications 1 à 7, dans lequel l'étape a) comporte les étapes :

$a_1$) prévoir un premier substrat (1'), sur lequel est formé l'ensemble de puces électroniques (P) ;
$a_2$) assembler un substrat temporaire (7) à l'ensemble de puces électroniques (P) ;
$a_3$) amincir le premier substrat (1') jusqu'à l'obtention de la première couche (1) ;
$a_4$) former les trous d'interconnexions (100) dans la première couche (1) ;
$a_5$) découper individuellement les puces électroniques (P).

9. Procédé selon l'une des revendications 1 à 8, dans lequel l'étape a) est exécutée de sorte que :

- la couche d'interconnexions (3) est formée sur la première couche (1),
- la matrice de pixels (2) est formée sur la couche d'interconnexions (3),
- l'empilement comprend une matrice de lentilles de focalisation (6), formé sur la matrice de pixels (2).

10. Procédé selon l'une des revendications 1 à 8, dans lequel l'étape a) est exécutée de sorte que :

- la matrice de pixels (2) est formée sur la première couche (1),
- la couche d'interconnexions (3) est formée sur la matrice de pixels (2),
- l'empilement comprend une matrice de lentilles de focalisation (6), formée sur la couche d'interconnexions (3).

11. Procédé selon l'une des revendications 1 à 10, dans lequel l'étape e) est exécutée de sorte que le matériau (5) est un polymère thermodurcissable, de préférence choisi parmi une résine époxy et une résine polysiloxane.

12. Procédé selon l'une des revendications 1 à 11, dans lequel l'étape f) est exécutée de sorte que les premier et second coefficients de dilatation thermique

vérifient : $\dfrac{\alpha_2}{\alpha_1} \geq 4$ , préférentiellement $\dfrac{\alpha_2}{\alpha_1} \geq 6$ , où :

- $\alpha_1$ est le coefficient de dilatation thermique de l'empilement,
- $\alpha_2$ est le coefficient de dilatation thermique du matériau (5) formé.

13. Procédé selon l'une des revendications 1 à 12, dans lequel l'étape f) est exécutée de sorte que le matériau (5) formé possède un module de Young supérieur à 100 MPa, de préférence supérieur à 1 GPa, plus préférentiellement supérieur à 3 GPa.

**Patentansprüche**

1. Verfahren zum kollektiven Biegen einer Gesamtheit von elektronischen Chips (P), umfassend die folgenden Schritte:

   a) Bereitstellen der Gesamtheit von elektronischen Chips (P), die zuvor ausgeschnitten wurden und jeweils ein Schichtsystem umfassen, das beinhaltet:

   - eine Pixelmatrix (2),
   - eine Verbindungsschicht (3), die mit der Pixelmatrix (2) elektrisch verbunden ist,
   - eine erste Schicht (1), die Verbindungslöcher (100) beinhaltet, die mit der Verbindungsschicht (3) elektrisch verbunden sind; wobei das Schichtsystem eine erste Dicke und einen ersten Wärmeausdehnungskoeffizienten besitzt;

   b) Montieren der Gesamtheit von ausgeschnittenen elektronischen Chips (P) auf ein Trägersubstrat (SS) auf der zu den ersten Schichten (1) entgegengesetzten Seite derart, dass ein Abstandsbereich (ZE) zwischen den benachbarten elektronischen Chips (P) gelassen wird;
   c) Formen einer Umverteilungsschicht (4), die metallische Leiterbahnen (40) umfasst, die mit den Verbindungslöchern (100) elektrisch verbunden sind, wobei die metallischen Leiterbahnen (40) seitliche Enden (400) aufweisen, die sich in jedem Abstandsbereich (ZE) erstrecken;
   d) Formen der metallischen Pfeiler (PM) auf den seitlichen Enden (400) der metallischen Leiterbahnen (40);
   e) Gießen eines Materials (5) auf die Umverteilungsschicht (4), wobei das Material (5) umfasst:

   - erste Abschnitte (50), die den ersten Schichten (1) der elektronischen Chips (P) gegenüberliegen,
   - zweite Abschnitte (51), die von den ersten Abschnitten (50) getrennt sind und sich in den Abstandsbereichen (ZE) um die metallischen Pfeiler (PM) herum erstrecken; wobei die ersten und zweiten Abschnitte (50, 51) des Materials (5) komplanar sind; wobei das Material (5) eine Formungstemperatur besitzt;

   f) Anwenden einer Wärmebehandlung bei der Formungstemperatur des Materials (5), wobei die ersten und zweiten Abschnitte (50, 51) des Materials (5) jeweils mit den ersten Schichten (1) und dem Trägersubstrat (SS) mechanisch fest verbunden sind, wobei das geformte Material (5) eine zweite Dicke besitzt, einen zweiten Wärmeausdehnungskoeffizienten, der strikt größer als der erste Wärmeausdehnungskoeffizient ist; wobei das Verhältnis zwischen den ersten und zweiten Wärmeausdehnungskoeffizienten, das Verhältnis zwischen den ersten und zweiten Dicken und die Formungstemperatur so angepasst werden, dass am Ende von Schritt f) das Schichtsystem jedes elektronischen Chips (P) gemäß einer vorbestimmten konvexen Form, die zur Pixelmatrix (2) ausgerichtet ist, bei einer gegebenen Betriebstemperatur des entsprechenden elektronischen Chips (P) gebogen ist; wobei die zweiten Abschnitte (51) des um die metallischen Pfeiler (PM) herum geformten Materials (5) am Ende von Schritt f) komplanar bleiben.

2. Verfahren nach Anspruch 1, bei welchem dem Schritt f) ein Schritt e₁) vorausgeht, der darin besteht, das Material (5) abzuflachen, so dass die metallischen Pfeiler (PM) freigelegt werden.

3. Verfahren nach Anspruch 1 oder 2, das einen Schritt g) umfasst, der darin besteht, Schweißkugeln (BS) auf den zweiten Abschnitten (51) des Materials (5) am Ende von Schritt f) zu formen, wobei die Schweißkugeln (BS) mit den metallischen Pfeilern (PM) in Kontakt sind.

4. Verfahren nach Anspruch 3, bei dem auf den Schritt g) ein Schritt h) folgt, der darin besteht, die elektronischen Chips (P) auszuschneiden.

5. Verfahren nach einem der Ansprüche 1 bis 4, bei dem der Schritt b) so ausgeführt wird, dass das Trägersubstrat (SS) im spektralen Betriebsbereich der elektronischen Chips (P) transparent ist.

6. Verfahren nach einem der Ansprüche 1 bis 5, bei dem der Schritt b) so ausgeführt wird, dass das Trägersubstrat (SS) Abstandshalter (9) umfasst, auf welche die ausgeschnittenen elektronischen Chips (P) montiert sind.

7. Verfahren nach einem der Ansprüche 1 bis 6, bei dem der Schritt c) die folgenden Schritte umfasst:

$c_1$) Formen einer dielektrischen Schicht (8), welche die Abstandsbereiche (ZE) derart ausfüllt, dass sie bündig mit den ersten Schichten (1) der elektronischen Chips (P) ist, wobei die dielektrische Schicht (8) mit dem Trägersubstrat (SS) mechanisch fest verbunden ist; $c_2$) Formen der Umverteilungsschicht (4), die sich auf den ersten Schichten (1) der elektronischen Chips (P) und auf der dielektrischen Schicht (8) erstreckt, wobei die Umverteilungsschicht (4) mit den ersten Schichten (1) und der dielektrischen Schicht (8) mechanisch fest verbunden ist.

8. Verfahren nach einem der Ansprüche 1 bis 7, bei dem der Schritt a) die folgenden Schritte umfasst:

$a_1$) Bereitstellen eines ersten Substrats (1'), auf dem die Gesamtheit von elektronischen Chips (P) geformt ist; $a_2$) Montieren eines temporären Substrats (7) an die Gesamtheit von elektronischen Chips (P); $a_3$) Dünnen des ersten Substrats (1') bis zum Erhalten der ersten Schicht (1); $a_4$) Formen der Verbindungslöcher (100) in der ersten Schicht (1); $a_5$) einzelnes Ausschneiden der elektronischen Chips (P).

9. Verfahren nach einem der Ansprüche 1 bis 8, bei dem der Schritt a) so ausgeführt wird, dass:

- die Verbindungsschicht (3) auf der ersten Schicht (1) geformt ist,
- die Pixelmatrix (2) auf der Verbindungsschicht (3) geformt ist,
- das Schichtsystem eine Fokussierungslinsenmatrix (6) umfasst, die auf der Pixelmatrix (2) geformt ist.

10. Verfahren nach einem der Ansprüche 1 bis 8, bei dem der Schritt a) so ausgeführt wird, dass:

- die Pixelmatrix (2) auf der ersten Schicht (1) geformt ist,
- die Verbindungsschicht (3) auf der Pixelmatrix (2) geformt ist,
- das Schichtsystem eine Fokussierungslinsenmatrix (6) umfasst, die auf der Verbindungsschicht (3) geformt ist.

11. Verfahren nach einem der Ansprüche 1 bis 10, bei dem Schritt e) so ausgeführt wird, dass das Material (5) ein wärmehärtbares Polymer ist, das bevorzugt unter einem Epoxidharz und einem Polysiloxanharz ausgewählt ist.

12. Verfahren nach einem der Ansprüche 1 bis 11, bei dem der Schritt f) so ausgeführt wird, dass die ersten und zweiten Wärmeausdehnungskoeffizienten die folgende Bedingung erfüllen:

$$\frac{a_2}{\alpha_1} \geq 4 \text{ , bevorzugt } \frac{\alpha_2}{\alpha_1} \geq 6 \text{ , worin:}$$

- $\alpha_1$ der Wärmeausdehnungskoeffizient des Schichtsystems ist,
- $\alpha_2$ der Wärmeausdehnungskoeffizient des geformten Materials (5) ist.

13. Verfahren nach einem der Ansprüche 1 bis 12, bei dem der Schritt f) so ausgeführt wird, dass das gebildete Material (5) einen Elastizitätsmodul von mehr als 100 MPa, bevorzugt mehr als 1 GPa, noch bevorzugter mehr als 3 GPa besitzt.

**Claims**

1. Process for collectively curving a set of electronic chips (P), comprising the steps:

a) providing the set of electronic chips (P), said chips having been diced beforehand and each comprising a stack comprising:

- a matrix-array of pixels (2),
- an interconnect layer (3), electrically connected to the matrix-array of pixels (2),
- a first layer (1), comprising through-vias (100) that are electrically connected to the interconnect layer (3); the stack possessing a first thickness and a first coefficient of thermal expansion;

b) joining the set of diced electronic chips (P) to a carrier substrate (SS), via the side opposite the first layers (1), so as to leave a spacing region (ZE) between adjacent electronic chips (P); c) forming a redistribution layer (4) comprising metal tracks (40) that are electrically connected to the through-vias (100), the metal tracks (40) having lateral ends (400) extending into each spacing region (ZE);

d) forming metal pillars (PM) on the lateral ends (400) of the metal tracks (40);

e) moulding a material (5) on the redistribution layer (4), the material (5) comprising:

- first segments (50), facing the first layers (1) of the electronic chips (P),
- second segments (51), which are separate from the first segments (50), and which extend in the spacing regions (ZE) around the metal pillars (PM); the first and second segments (50, 51) of the material (5) being coplanar; the material (5) possessing a formation temperature;

f) applying a heat treatment at the formation temperature of the material (5), the first and second segments (50, 51) of the material (5) being mechanically attached to the first layers (1) and to the carrier substrate (SS), respectively, the formed material (5) possessing a second thickness, and a second coefficient of thermal expansion strictly higher than the first coefficient of thermal expansion; the ratio between the first and second coefficients of thermal expansion, the ratio between the first and second thicknesses and the formation temperature being adapted so that, at the end of step f), the stack of each electronic chip (P) is curved with a preset convex shape, which is oriented toward the matrix-array of pixels (2), at a given corresponding operating temperature of the electronic chip (P); the second segments (51) of the material (5) formed around the metal pillars (PM) remaining coplanar at the end of step f).

2. Process according to Claim 1, wherein step f) is preceded by a step $e_1$) consisting in planarizing the material (5) so as to free the metal pillars (PM).

3. Process according to Claim 1 or 2, comprising a step g) consisting in forming solder bumps (BS) on the second segments (51) of the material (5) at the end of step f), the solder bumps (BS) making contact with the metal pillars (PM).

4. Process according to Claim 3, wherein step g) is followed by a step h) consisting in dicing the electronic chips (P).

5. Process according to one of Claims 1 to 4, wherein step b) is executed so that the carrier substrate (SS) is transparent in the spectral domain of operation of the electronic chips (P).

6. Process according to one of Claims 1 to 5, wherein step b) is executed so that the carrier substrate (SS) comprises spacers (9) to which the diced electronic chips (P) are joined.

7. Process according to one of Claims 1 to 6, wherein step c) comprises the steps:

$c_1$) forming a dielectric layer (8) that fills the spacing regions (ZE) so as to lie flush with the first layers (1) of the electronic chips (P), the dielectric layer (8) being mechanically attached to the carrier substrate (SS);

$c_2$) forming the redistribution layer (4), the latter extending over the first layers (1) of the electronic chips (P) and over the dielectric layer (8), the redistribution layer (4) being mechanically attached to the first layers (1) and to the dielectric layer (8).

8. Process according to one of Claims 1 to 7, wherein step a) comprises the steps:

$a_1$) providing a first substrate (1'), on which is formed the set of electronic chips (P);

$a_2$) joining a temporary substrate (7) to the set of electronic chips (P);

$a_3$) thinning the first substrate (1') until the first layer (1) is obtained;

$a_4$) forming through-vias (100) in the first layer (1);

$a_5$) dicing the electronic chips (P) individually.

9. Process according to one of Claims 1 to 8, wherein step a) is executed so that:

- the interconnect layer (3) is formed on the first layer (1),
- the matrix-array of pixels (2) is formed on the interconnect layer (3),
- the stack comprises a matrix-array of focusing lenses (6), formed on the matrix-array of pixels (2).

10. Process according to one of Claims 1 to 8, wherein step a) is executed so that:

- the matrix-array of pixels (2) is formed on the first layer (1),
- the interconnect layer (3) is formed on the matrix-array of pixels (2),
- the stack comprises a matrix-array of focusing lenses (6), formed on the interconnect layer (3).

11. Process according to one of Claims 1 to 10, wherein step e) is executed so that the material (5) is a thermosetting polymer, preferably chosen from an epoxy resin and a polysiloxane resin.

12. Process according to one of Claims 1 to 11, wherein step f) is executed so that the first and second coefficients of thermal expansion respect:

$$\frac{\alpha_2}{\alpha_1} \geq 4$$ , and preferably $$\frac{\alpha_2}{\alpha_1} \geq 6$$ , where:

- $\alpha_1$ is the coefficient of thermal expansion of the stack,
- $\alpha_2$ is the coefficient of thermal expansion of the formed material (5).

13. Process according to one of Claims 1 to 12, wherein step f) is executed so that the formed material (5) possesses a Young's modulus higher than 100 MPa, preferably higher than 1 GPa, and more preferably higher than 3 GPa.

Fig. 1a

Fig. 1b

Fig. 1d

Fig. 1c

Fig. 2a

Fig. 2b

Fig. 2d

Fig. 2c

Fig. 3a

Fig. 3b

Fig. 3d

Fig. 3c

Fig. 3e

Fig. 3f

Fig. 3h

Fig. 3g

Fig. 3i

Fig. 3j

Fig. 4a

Fig. 4b

Fig. 4d

Fig. 4c

Fig. 4e

Fig. 4f

Fig. 4h

Fig. 4g

Fig. 4i

Fig. 4j

*Fig. 5*

*Fig. 6*

*Fig. 7*

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 20060038183 A1

- US 2009115875 A

**Littérature non-brevet citée dans la description**

- ASM Ready Reference : Thermal Properties of Metals. ASM International, 2002

- **B. CASSEL et al.** Coefficient ofThermal Expansion Measurement using the TMA 4000. PerkinElmer, Inc, 2013